Europäisches Patentamt

European Patent Office

Office européen des brevets

(19)

(11) Numéro de publication : **0 413 644 B1**

# (12) FASCICULE DE BREVET EUROPEEN

(45) Date de publication du fascicule du brevet :
**02.11.94 Bulletin 94/44**

(51) Int. Cl.⁵ : **H04N 5/93, H04N 5/91**

(21) Numéro de dépôt : **90420373.4**

(22) Date de dépôt : **09.08.90**

(54) **Circuit de comparaison de signaux haute fréquence modulés en amplitude.**

(30) Priorité : **16.08.89 FR 8911227**

(43) Date de publication de la demande :
**20.02.91 Bulletin 91/08**

(45) Mention de la délivrance du brevet :
**02.11.94 Bulletin 94/44**

(84) Etats contractants désignés :
**DE FR GB IT NL**

(56) Documents cités :
**EP-A- 0 049 989**
**EP-A- 0 136 816**
**US-A- 4 600 952**
**PATENT ABSTRACTS OF JAPAN, vol. 8, no.**
**185 (E-262)[1622], 24 août 1984; & JP-A-59 75**
**782 (SONY K.K.) 28-04-1084**

(73) Titulaire : **SGS-THOMSON**
**MICROELECTRONICS S.A.**
**7, Avenue Galliéni**
**F-94250 Gentilly (FR)**

(72) Inventeur : **Perroud, Philipp**
**2, Impasse des Lécheres**
**F-38240 Meylan (FR)**
Inventeur : **Jaffard, Jean-Luc**
**4bis, Rue du Cotaire**
**F-38120 Saint Egrève (FR)**

(74) Mandataire : **de Beaumont, Michel**
**1bis, rue Champollion**
**F-38000 Grenoble (FR)**

EP 0 413 644 B1

## Description

La présente invention concerne des circuits de comparaison de signaux modulés en amplitude, et plus particulièrement des circuits de comparaison de signaux provenant de têtes de magnétoscopes.

Certains magnétoscopes comprennent quatre têtes, deux pour un mode de fonctionnement "durée normale" appelées S1 et S2 qui servent aussi bien pour l'enregistrement que pour la lecture, et deux pour un mode de fonctionnement "longue durée" appelées L1 et L2 qui servent également à la fois pour l'enregistrement et la lecture. En général, la durée d'un enregistrement ou d'une lecture dans ce dernier mode est double par rapport au mode "durée normale".

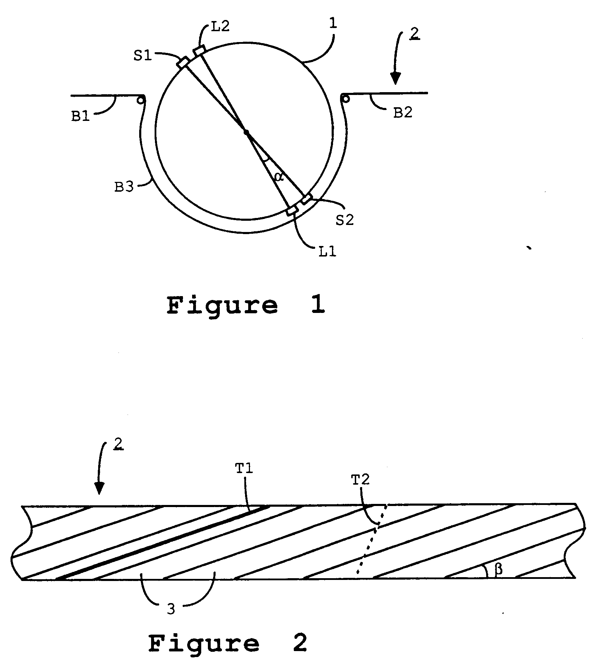

Les quatre têtes sont solidaires d'un tambour circulaire qui est représenté de façon très schématique, en vue de dessus, sur la figure 1 avec la référence 1. Les deux têtes S1 et S2 sont diamétralement opposées de même que les têtes L1 et L2. De plus, les têtes L1 et L2 sont décalées d'un angle α généralement faible, de l'ordre du millième de radian, par rapport aux têtes S2 et S1, respectivement.

Les têtes de magnétoscope enregistrent ou lisent des données (image et son) sur une bande magnétique 2 représentée sur les figures 1 et 2. Les données sont contenues dans des pistes 3 rectilignes qui présentent un petit angle β par rapport à l'axe longitudinal de la bande. Les pistes 3 sont accolées les unes aux autres.

En fonctionnement, le tambour tourne sur lui-même et la bande défile en étant plaquée contre le tambour sur plus de 180° (figure 1). Les têtes sont animées d'une vitesse relative par rapport à la bande. Dans le mode "durée normale", chacune des têtes S1 et S2, l'une après l'autre, intéragit avec une piste unique. Dans le mode "longue durée", ce sont les têtes L1 et L2 qui intéragissent chacune avec une piste unique l'une après l'autre.

Sur les parties de la bande non plaquées contre le tambour, désignées par les références B1 et B2 sur la figure 1, l'axe longitudinal de la bande est perpendiculaire à l'axe du tambour. Sur la partie B3 de la bande plaquée contre le tambour, l'axe longitudinal de la bande en chaque point présente avec l'axe du tambour un angle un peu différent de π/2 de sorte que, pour une vitesse relative adaptée des têtes par rapport à la bande, les têtes suivent une trajectoire T1, représentée sur la figure 2, parallèle à l'axe longitudinal des pistes.

En outre, de tels magnétoscopes à quatre têtes peuvent en général fonctionner dans un mode supplémentaire appelé mode "recherche" dans lequel les images sont présentées en accéléré pour rechercher rapidement des séquences particulières. Dans un tel mode, la vitesse de défilement de la bande est augmentée et la trajectoire des têtes sur la bande n'est plus parallèle à l'axe longitudinal des pistes. Une telle trajectoire T2 d'une tête en mode "recherche" est représentée en pointillés sur la figure 2. Dans ce cas, la tête progresse d'une part à l'intérieur des pistes et d'autre part sur les zones de séparation entre les pistes. Or ce passage des têtes sur les zones de séparation détériore la qualité de l'image. En effet, en mode "durée normale" ou en mode "longue durée", le signal obtenu à partir des pistes au cours d'une lecture est un signal haute fréquence (100 kHz à 10 MHz) d'amplitude constante. En mode "recherche", l'amplitude du signal haute fréquence diminuera à chaque croisement de la tête avec une zone de séparation entre pistes. Le signal résultant sera ainsi un signal haute fréquence modulé en amplitude. Les diminutions d'amplitude au niveau des zones de séparation des pistes se traduisent par des barres de bruit sur les images.

Il a alors été proposé dans l'art antérieur, pour éliminer ces barres de bruit, une solution dans laquelle on n'utilise plus, en mode "recherche", uniquement les têtes de type S (mode "durée normale") ou bien uniquement les têtes de type L (mode "longue durée"). En effet, puisque la détérioration de l'image correspond aux diminutions des signaux, il a été prévu un circuit pour comparer l'amplitude des signaux associés à la tête S à celle des signaux associés à la tête L d'un couple de têtes adjacentes sur le tambour (couples (S1, L2) ou (S2, L1)) et pour choisir celle des têtes pour laquelle l'amplitude est la plus élevée. De plus, dans les magnétoscopes mettant en oeuvre une telle solution, les signaux en provenance des têtes S et des têtes L sont déphasés d'une valeur très voisine de π. Cela peut être notamment obtenu en ajustant la vitesse de défilement de la bande. Les performances sont ainsi optimisées, un signal décroissant étant remplacé par un signal croissant, et ainsi de suite.

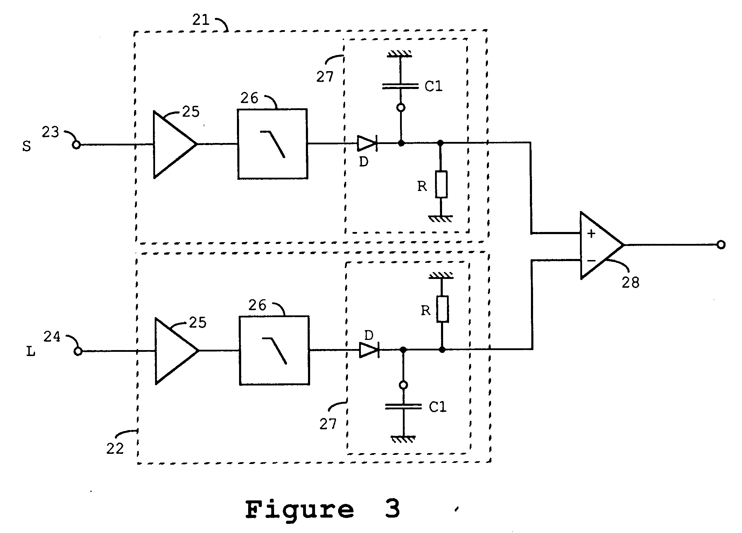

Un tel circuit est représenté sur la figure 3. Il comprend deux branches identiques 21 et 22, la branche 21 recevant sur son entrée 23 des signaux en provenance d'une tête S "durée normale" et la branche 22 recevant sur son entrée 24 des signaux en provenance d'une tête L "longue durée".

Il est prévu dans chaque branche, en entrée, un amplificateur 25. La sortie de cet amplificateur est connectée à l'entrée d'un filtre passe-bas 26 utilisé pour éliminer les pics de bruit. Un détecteur 27, formé de façon usuelle d'une diode D, d'une capacité C1 et d'une résistance R, a son entrée reliée à la sortie du filtre passe-bas. Ce détecteur a une constante de temps R x C1 et il fournit en sortie un signal correspondant à l'enveloppe supérieure du signal haute fréquence modulé. La sortie du détecteur constitue la sortie de la branche.

La sortie de chacune des branches est connectée à une entrée d'un même comparateur 28. Selon le signe de la différence de tension entre ses deux entrées, le comparateur délivre un "1" logique (en général la tension d'alimentation 5 V), ou un "0" logique (en général O V), ce qui détermine le choix de la tête associée à l'amplitude maximale.

Cependant, le circuit de la figure 3 présente une sensibilité limitée. En effet, les tensions des signaux d'entrée peuvent atteindre 600 mV dans de bonnes conditions, et elles peuvent ne pas dépasser 60 mV dans le cas d'enregistrements de mauvaise qualité par exemple. Or si l'on veut amplifier de façon importante les signaux de faible intensité, en prenant un gain de l'amplificateur de 15 par exemple, les signaux en sortie de l'amplificateur atteindraient 5 V dans le cas de signaux initialement de grande intensité. Cela entraînerait un fonctionnement de l'amplificateur en régime de saturation. Ainsi, le gain ne doit pas être trop élevé, il ne doit pas dépasser 7 ou 8.

En outre, le détecteur doit avoir une constante de temps R x C1 importante pour assurer un bon traitement. Elle est de l'ordre de 1 ms. La résistance est de l'ordre de 10 k$\Omega$, et la capacité C1 est de l'ordre de 100 nF. La résistance R est intégrable, mais la capacité C1 est trop importante pour pouvoir être intégrée ; il faudrait qu'elle soit inférieure à environ 10 à 20 pF. Or pour diminuer C1 à une telle valeur, l'ordre de grandeur de R devrait être de 100 M$\Omega$, ce qui est très grand et donnerait une résistance intégrée très dispersée. Le circuit de la figure 3 n'est donc pas entièrement intégrable.

Un objet de la présente invention est de prévoir un circuit de comparaison de signaux haute fréquence modulés en amplitude de grande sensibilité.

Un autre objet de la présente invention est de prévoir un tel circuit de comparaison entièrement intégrable.

Pour atteindre ces objets, la présente invention prévoit un circuit de comparaison des signaux d'un magnétoscope pouvant fonctionner dans un premier mode "durée normale" en utilisant un premier type de têtes, dans un deuxième mode "longue durée" en utilisant un deuxième type de têtes et dans un troisième mode "recherche". Ce circuit de comparaison possède deux branches identiques de traitement de signaux dont l'une est reliée en entrée à une tête du premier type et l'autre à une tête du deuxième type, et dont chacune est connectée en sortie à une entrée d'un même premier comparateur pour choisir en mode "recherche" celle des deux têtes qui présente l'amplitude de signal la plus grande. Chaque branche comprend, connectés l'un à la suite de l'autre, un filtre passe-haut, un amplificateur à gain variable, un multiplieur de signal par lui-même, un filtre passe-bas et un amplificateur de capacité comprenant un deuxième comparateur à sortie en courant dont une première entrée constitue l'entrée de l'amplificateur de capacité et dont la deuxième entrée est reliée d'une part à la masse par l'intermédiaire d'une capacité et d'autre part à la sortie de l'amplificateur de capacité. L'entrée du filtre passe-haut constitue l'entrée de la branche, et la sortie de l'amplificateur de capacité constitue la sortie de la branche qui est reliée à l'amplificateur à gain variable pour assurer un contrôle de ce gain.

Ces objets, caractéristiques et avantages ainsi que d'autres de la présente invention seront exposés plus en détail dans la description d'un mode de réalisation particulier faite en relation avec les figures jointes parmi lesquelles :

la figure 1, déjà décrite, représente de façon très schématique en vue de dessus un tambour de magnétoscope à quatre têtes ;

la figure 2, déjà décrite, représente une bande utilisée dans un magnétoscope ;

la figure 3, déjà décrite, représente un circuit de comparaison selon l'art antérieur ;

la figure 4 représente un circuit de comparaison selon la présente invention ;

la figure 5 représente des signaux à différentes étapes du traitement par le circuit de comparaison de la figure 4 ; et

la figure 6 représente une variante du circuit de comparaison de la figure 4.

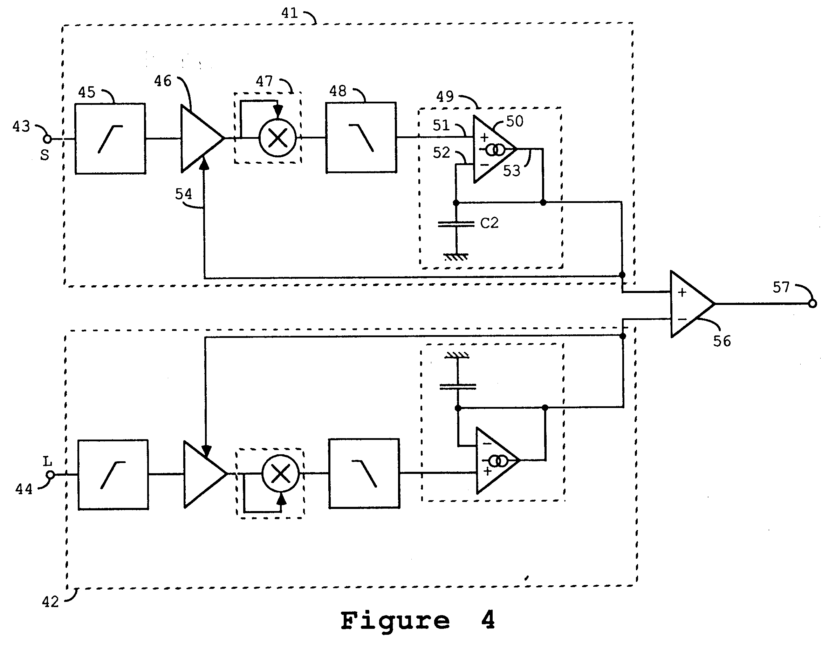

La figure 4 représente un circuit de comparaison de signaux haute fréquence modulés en amplitude selon la présente invention. Il comprend deux branches 41 et 42 identiques. La branche 41 reçoit sur une entrée 43 des signaux en provenance d'une tête S (mode "durée normale"), et la branche 42 reçoit des signaux provenant d'une tête L (mode "longue durée") sur une entrée 44.

L'entrée de chaque branche est constituée par l'entrée d'un filtre passe-haut 45 dont la sortie est connectée à l'entrée d'un amplificateur à gain variable 46. La sortie de cet amplificateur 46 est reliée à l'entrée d'un multiplieur 47. Un filtre passe-bas 48 a son entrée reliée à la sortie du multiplieur et sa sortie reliée à l'entrée d'un amplificateur de capacité 49. Celui-ci comprend de façon usuelle un comparateur à sortie en courant 50 dont une première entrée 51, ou entrée positive, constitue l'entrée de l'amplificateur de capacité et dont une deuxième entrée 52, ou entrée négative, est connectée, d'une part, à une borne d'une capacité C2 dont l'autre borne est reliée à la masse, d'autre part, à la sortie 53 du comparateur 50. Cette sortie 53 est reliée en retour à une entrée de contrôle de gain 54 de l'amplificateur 46. La sortie de l'amplificateur de capacité constitue en outre la sortie de la branche.

Les sorties des branches 41 et 42 sont reliées aux entrées + et - d'un comparateur 56 dont la sortie 57 forme la sortie du circuit de comparaison.

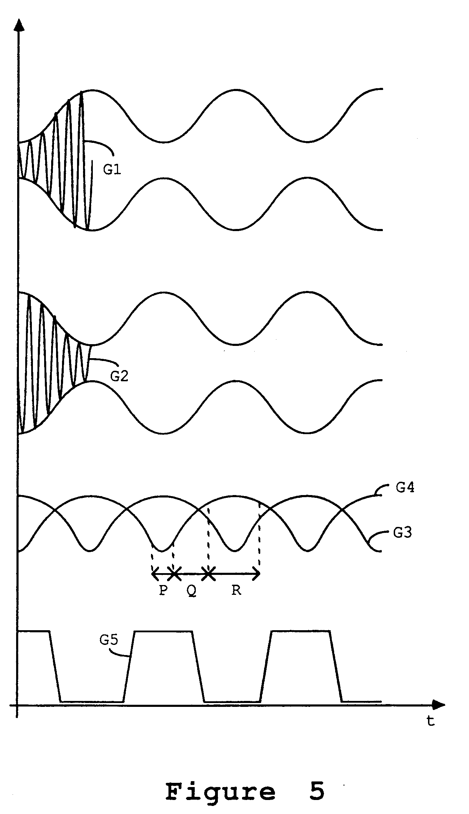

Le signal de tension en provenance de la tête S reçu sur la borne d'entrée 43 du circuit est représenté en fonction du temps sur la courbe G1 de la figure 5. Le signal en provenance de la tête L appliqué sur la borne d'entrée 44 du circuit est représenté sur la courbe G2 de la figure 5. Ce sont des signaux haute fréquence du type sinusoïdal modulés en amplitude. Leur déphasage a été représenté égal à π.

Le filtre passe-haut 45 a par exemple une fréquence de coupure de 1 MHz. Le signal sortant du filtre est amplifié par l'amplificateur 46 à gain variable, la façon dont ce gain est contrôlé étant précisée ci-après. Ensuite, dans le multiplieur 47, le signal est multiplié par lui-même. Puisque le signal incident est du type sinusoïdal, le signal délivré par le multiplieur est formé d'une composante continue et d'harmoniques pairs de la fréquence d'entrée. Le filtre passe-bas 48, de fréquence de coupure de 100 kHz, ne laisse passer que cette composante continue.

Sans la présence du filtre passe-haute en début de branche, les harmoniques de fréquence double auraient une fréquence minimum de 200 kHz puisque les signaux en provenance des têtes varient à partir de 100 kHz. En utilisant le filtre passe-haut 45, cette fréquence minimum est de 2 MHz. Le filtrage au niveau du filtre passe-bas est ainsi plus efficace en prévoyant le filtre passe-haut.

La composante continue en sortie du filtre passe-bas varie elle-même en fonction du temps puisque le signal en provenance des têtes est modulé en amplitude. La fréquence de ce signal est de l'ordre de 10 kHz. Celui-ci est introduit dans l'amplificateur de capacité 49 qui est un dispositif couramment utilisé dans la technique pour réaliser un lissage d'un signal incident. Lorsque la différence de tension entre les entrées 51 et 52 du comparateur 50 est positive, celui-ci fournit sur sa sortie un courant I. Puisque les comparateurs 50 et 56, par conception, ont des courants d'entrée très faibles devant leurs courants de sortie, le courant I sert uniquement à charger la capacité C2. La charge de la capacité est réalisée en accord avec la relation

$$I = C2 (\Delta V/\Delta T)$$

où $\Delta V$ est la différence de tension aux bornes de la capacité et $\Delta T$ la durée de la charge. Il est défini, pour une différence de tension $\Delta V$, une constante de temps donnée par

$$\tau = (C2/I) \Delta V.$$

Un lissage de bonne qualité sera obtenu pour une constante de temps importante, de l'ordre de 10 μs. Avec des valeurs adaptées $\Delta V = 1V$ et $I = 1 μA$, la capacité C2 a une valeur C2 = 10 pF. Cette capacité est intégrable.

Le signal lissé présent en sortie de l'amplificateur de capacité est envoyé en retour à l'amplificateur 46 afin d'en contrôler le gain. Cet amplificateur a un gain qui varie de façon sensiblement linéaire entre une valeur importante quand le signal de contrôle envoyé en retour est faible et une valeur faible quand le signal de contrôle est important.

En raison, d'une part, du contrôle du gain de l'amplificateur 46 et, d'autre part, du fait que l'on considère des amplitudes de signaux au carré, le signal à la sortie d'une branche aura l'allure illustrée sur les courbes G3 (branche 41) et G4 (branche 42) de la figure 5. Les signaux associés aux courbes G3 et G4 sont introduits dans le comparateur 56.

Le gain de l'amplificateur 46 peut varier entre 1 et 20 par exemple. Lorsque l'amplitude (a) du signal en sortie de l'amplificateur 46 est faible, le gain est important (proche de 20) mais la composante au carré $a^2$ reste relativement faible, comme cela est représenté sur une partie P de la courbe G4. Sur une partie Q, l'amplitude a est plus importante et le gain a diminué à une valeur qui peut varier autour de 10. A cause de l'élévation au carré de l'amplitude, on obtient une augmentation du signal, ainsi qu'une augmentation de la vitesse de variation de ce signal. Ainsi, comme la sélection de l'une ou l'autre des branches (croisement des courbes) est principalement réalisée au niveau de telles parties Q des courbes puisque le déphasage entre ces dernières est de l'ordre de π, des signaux de plus faibles intensités pourront être comparés et la sensibilité est accrue. En outre, puisque la vitesse de variation est plus élevée, la sélection est réalisée avec une meilleure précision.

Enfin, lorsque l'amplitude a est proche de son maximum, le gain est faible ; il est voisin de 1. Les courbes présentent une forme aplatie (partie R de la courbe G4). Des signaux en provenance des têtes avec une amplitude de 0,6 V sont compatibles avec le circuit de comparaison, cette valeur élevée au carré restant inférieure aux valeurs limites admises.

Ainsi ce circuit selon l'invention, en plus de sa sensibilité accrue, accepte des signaux d'intensité importante. En outre, puisque la capacité C2 peut être intégrée, il est entièrement intégrable.

Le comparateur 56 représenté sur la figure 4 fournit sur sa sortie un signal à haut niveau (5 V) si l'intensité du signal en provenance de la branche 41 est supérieure à celle du signal provenant de la branche 42, et il fournit un signal de butée basse (0 V) dans le cas contraire. Cela permet de déterminer le choix de la tête associée à l'amplitude maximale. Le signal de sortie du comparateur est représenté par la courbe G5 de la figure 5.

Dans le circuit de la figure 1, la constante de temps du détecteur 27 est de l'ordre de 1 ms. Il n'est pas possible de remplacer ce détecteur par un amplificateur de capacité dans le but de réaliser un circuit intégré car la capacité aurait une valeur trop importante (pour un courant de 1 μA, on devrait avoir une valeur de capacité de 100 nF).

Les têtes de type S ont des caractéristiques différentes de celles des têtes de type L. Le rapport signal-sur-bruit associé aux têtes S est supérieur à celui associé aux tête L. Pour les faibles intensités pouvant être détectées par le circuit selon l'invention en raison de sa grande sensibilité, il pourrait être souhaitable de choisir la tête S plutôt que la tête L alors que celle-ci fournit des signaux de plus grande amplitude.

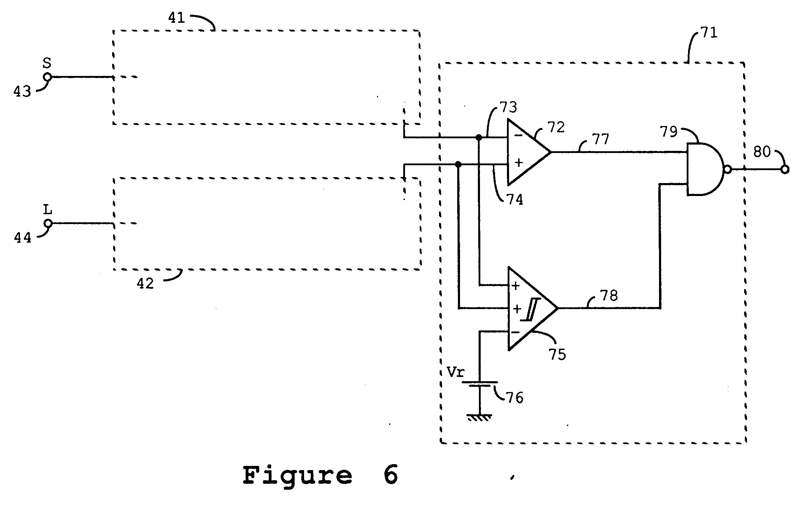

Cela est atteint, selon une variante de la présente invention, en remplaçant le comparateur 56 de la figure 4 par un dispositif 71 représenté sur la figure 6. Ce dispositif 71 comprend un comparateur 72 qui reçoit sur une première entrée 73, ou entrée négative, le signal en provenance de la branche 41 et sur une deuxième entrée 74, ou entrée positive, le signal en provenance de la branche 42. Dans le dispositif 71, les entrées positive et négative du comparateur 72 sont inversées par rapport à celles du comparateur 56 de la figure 4.

Les entrées 73 et 74 sont chacune connectées à une entrée positive d'un comparateur à trois entrées avec hystérésis 75 classique dont une entrée négative est reliée à une source de tension 76 qui fournit une tension de référence Vr. Les sorties 77, 78 des comparateurs 72 et 75, respectivement, sont chacune connectées à une entrée d'une porte NON-ET 79 dont la sortie 80 constitue la sortie du dispositif 71.

Si les tensions sur les deux entrées 73 et 74 sont supérieures à la tension de référence Vr, ou si la tension sur l'une seulement de ces deux entrées est supérieure à Vr, la sortie du comparateur à hystérésis est mise à 1. On retrouve alors sur la sortie du dispositif 71 un signal haut quand le signal associé à la tête S est supérieur au signal associé à la tête L, et inversement. On est ramené dans ce cas au fonctionnement du circuit de la figure 4.

Par contre, si les tensions sur les deux entrées 73 et 74 sont inférieures à la tension de référence, la sortie 78 du comparateur avec hystérésis est mise à 0. La sortie 80 de la porte NON-ET est alors mise à 1. Ainsi, on sélectionne la tête S lorsque les deux signaux en sortie des branches 41 et 42 sont inférieures à une tension de référence, même si le signal associé à la tête L est supérieur au signal associé à la tête S.

**Revendications**

1. Circuit de comparaison adapté à un magnétoscope pouvant fonctionner dans un premier mode "durée normale" en utilisant un premier type de têtes (S), dans un deuxième mode "longue durée" en utilisant un deuxième type de têtes (L) et dans un troisième mode "recherche", ce circuit de comparaison possédant deux branches (41, 42) identiques dont l'une (41) est reliée à une tête du premier type et l'autre (42) à une tête du deuxième type, et dont chacune est connectée en sortie à une entrée d'un même moyen de comparaison (56) pour choisir en mode "recherche" celle des deux têtes qui présente l'amplitude de signal la plus grande, caractérisé en ce que chaque branche comprend, en série, un filtre passe-haut (45), un amplificateur (46) à gain variable, un multiplieur (47) de signal par lui-même, un filtre passe-bas (48) et un amplificateur de capacité (49) comprenant un premier comparateur à sortie en courant (50) dont une première entrée (51) constitue l'entrée de l'amplificateur de capacité et dont la deuxième entrée (52) est reliée d'une part à la masse par l'intermédiaire d'une capacité (C2) et d'autre part à la sortie (53) de cet amplificateur de capacité, l'entrée du filtre passe-haut constituant l'entrée de la branche, et la sortie de l'amplificateur de capacité constituant la sortie de la branche qui est reliée à l'amplificateur à gain variable pour assurer un contrôle de ce gain.

2. Circuit de comparaison selon la revendication 1, caractérisé en ce que le gain de l'amplificateur (46) à gain variable de chaque branche est compris entre 1 et 20.

3. Circuit de comparaison selon la revendication 1 dans lequel le moyen de comparaison (56) est constitué par un dispositif (71) qui comprend un deuxième comparateur (72) à une entrée négative (73) et une entrée positive (74) qui sont chacune reliée à une entrée positive d'un troisième comparateur à trois entrées avec hystérésis (75) dont la troisième entrée, ou entrée négative, est connectée à une source de tension de référence (Vr), les sorties (77, 78) des deuxième et troisième comparateurs, respectivement, étant connectées chacune à une entrée d'une porte NON-ET (79) dont la sortie (80) constitue la sortie du dispositif (71), d'où il résulte que le signal associé à l'entrée négative du deuxième comparateur est sélectionné lorsque les tensions sur les deux entrées de ce deuxième comparateur sont inférieures à la tension de référence.

**Patentansprüche**

1. Vergleichsschaltung, welche einem Videokassettenrekorder zugeordnet ist, der in einem ersten "Normale Dauer"-Modus arbeiten kann, wobei er eine erste Art von Köpfen (S) verwendet, und in einem zweiten "Lange Dauer"-Modus arbeiten kann, wobei er eine zweite Art von Köpfen (L) verwendet, und in einem dritten "Such"-Modus arbeiten kann, mit zwei identischen Zweigen (41, 42), wobei der Eingang des einen Zweiges (41) mit einem Kopf der ersten Art verbunden ist und der Eingang des anderen Zweiges (42) mit einem Kopf der zweiten Art verbunden ist und die Ausgänge beider Zweige jeweils mit einem Eingang einer Vergleichsvorrichtung (56) verbunden ist, welche im "Such"-Modus den Kopf auswählt, der das Signal mit der höchsten Amplitude empfängt, dadurch gekennzeichnet, daß jeder Zweig in Reihe ein Hochpaß-Filter (45), einen Verstärker (46) mit variablem Verstärkungsfaktor, einen Multiplizierer (47), welcher das Signal mit sich selbst multipliziert, ein Tiefpaß-Filter (48) und einen Kapazitätsverstärker (49) aufweist, wobei der Kapazitätsverstärker (49) einen ersten Vergleicher (50) umfaßt, welcher einen Ausgangsstrom liefert, dessen erster Eingang (51) mit dem Eingang des Kapazitätsverstärkers verbunden ist und dessen zweiter Eingang (52) einerseits über einen Kondensator (C2) mit Masse verbunden ist und andererseits mit dem Ausgang des Kapazitätsverstärkers verbunden ist, wobei der Eingang des Hochpaß-Filters den Eingang des Zweiges bildet und der Ausgang des Kapazitätsverstärkers den Ausgang des Zweiges bildet, welcher zur Verstärkungssteuerung mit dem Verstärker mit variablem Verstärkungsfaktor verbunden ist.

2. Vergleichsschaltung nach Anspruch 1, dadurch gekennzeichnet, daß die Verstärkung des Verstärkers (46) mit variablem Verstärkungsfaktor jedes Zweiges im Bereich von 1 bis 20 liegt.

3. Vergleichsschaltung nach Anspruch 1, bei der die Vergleichsvorrichtung (56) von einer Baugruppe (71) gebildet ist, welche einen zweiten Vergleicher (72) mit einem negativen Eingang (73) und einem positiven Eingang (74) aufweist, wobei jeder der Eingänge mit einem positiven Eingang eines dritten Hysteresevergleichers (75) mit drei Eingängen verbunden ist, dessen dritter Eingang, oder negativer Eingang, mit einer Bezugsspannungsquelle (Vr) verbunden ist, wobei jeder der Ausgänge (77, 78) des zweiten bzw. dritten Vergleichers mit einem Eingang eines NAND-Gates (79) verbunden ist, dessen Ausgang (80) den Ausgang der Baugruppe (71) bildet, wobei das dem negativen Eingang des zweiten Vergleichers zugeordnete Signal gewählt wird, wenn die Spannungen an den beiden Eingängen dieses zweiten Vergleichers niedriger sind als die Bezugsspannung.

**Claims**

1. A comparison circuit associated with a video tape recorder able to operate in a first "normal duration" mode by using a first type of heads (S), in a second "long duration" mode by using a second type of heads (L) and in a third "search" mode, this comparison circuit having two identical legs (41, 42), the input of one leg (41) being connected to a head of the first type and the input of the other leg (42) to a head of the second type, the outputs of both legs being connected to a respective input of a comparison means (56) for selecting in "search" mode the head which receives the highest signal amplitude, characterized in that each branch comprises, in series, a high-pass filter (45), a variable gain amplifier (46), a multiplier (47) multiplying the signal by itself, a low-pass filter (48) and a capacitance amplifier (49) comprising a first comparator (50) supplying an output current, the first input (51) of which constitutes the input of the capacitance amplifier and the second input (52) is connected, on the one hand, to the ground through a capacitor (C2) and, on the other hand, to the output (53) of said capacitance amplifier, the input of the high-pass filter constituting the leg input and the output of the capacitance amplifier constituting the leg output which is connected to said variable gain amplifier for gain control.

2. A comparison circuit according to claim 1, characterized in that the gain of said variable gain amplifier (46) of each leg ranges from 1 to 20.

3. A comparison circuit according to claim 1, wherein said comparison means (56) is constituted by a device (71) which comprises a second comparator (72) having a negative input (73) and a positive input (74) each of which is connected to a positive input of a third three-input hysteresis comparator (75), the third input of which, or negative input, is connected to a reference voltage source (Vr), each of the outputs (77, 78) of the second and third comparators, respectively, being connected to an input of an NAND gate (79), the output (80) of which constitutes the output of the device (71), whereby the signal associated with the negative input of the second comparator is selected when the voltages on the two inputs of this second comparator are lower than said reference voltage.

Figure 1

Figure 2

Figure 3

Figure 4

EP 0 413 644 B1

**Figure 5**

Figure 6

EP 0 413 644 B1